(19) Europäisches Patentamt / European Patent Office / Office européen des brevets

(11) **EP 4 253 319 A1**

(12) **EUROPEAN PATENT APPLICATION**

(43) Date of publication:
04.10.2023 Bulletin 2023/40

(21) Application number: 23162577.3

(22) Date of filing: **17.03.2023**

(51) International Patent Classification (IPC):
***C01B 33/146*** *(2006.01)*      ***C09G 1/02*** *(2006.01)*
***C09K 3/14*** *(2006.01)*

(52) Cooperative Patent Classification (CPC):
**C01B 33/146; C09G 1/02; C09K 3/1436**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2022   JP 2022053011**

(71) Applicant: **Fujimi Incorporated
Kiyosu-shi, Aichi 452-8502 (JP)**

(72) Inventors:
• **TSUBOTA, Shogo
Aichi, 452-8502 (JP)**

• **ASHITAKA, Keiji
Aichi, 452-8502 (JP)**
• **ITO, Masaaki
Aichi, 452-8502 (JP)**
• **HIRANO, Tatsuhiko
Aichi, 452-8502 (JP)**
• **SUZUKI, Shota
Aichi, 452-8502 (JP)**

(74) Representative: **Maiwald GmbH
Elisenhof
Elisenstraße 3
80335 München (DE)**

(54) **SULFONIC ACID-MODIFIED COLLOIDAL SILICA**

(57)    The present invention provides a means capable of further improving stability and washability under acidic conditions. The present invention is sulfonic acid-modified colloidal silica having an amount of sulfonic acid groups per 1 g of particles of 1.5 $\mu$mol/g or more and 13.0 $\mu$mol/g or less.

**EP 4 253 319 A1**

**Description**

**BACKGROUND OF THE INVENTION**

Field of the Invention

The present invention relates to sulfonic acid-modified colloidal silica.

Description of the Related Art

In recent years, along with multilayer wiring of surfaces of the semiconductor substrates, so-called chemical mechanical polishing (CMP) technologies have been utilized to physically polish and planarize semiconductor substrates upon manufacturing devices. CMP is a method for planarizing surfaces of objects to be polished such as semiconductor substrates by using a polishing composition (slurry) containing abrasive grains such as silica, alumina and ceria, an anticorrosive, a surfactant, and the like, and specifically, CMP has been used in steps such as shallow trench isolation (STI), planarization of interlayer insulating films (ILD films), tungsten plug formation, and formation of multilayer wiring composed of copper and a low dielectric constant film.

Polishing compositions (slurries) used in CMP have been variously investigated according to types of objects to be polished, and the same applies to abrasive grains contained in the polishing compositions. For example, Japanese Patent Laid-Open No. 2012-40671 (corresponding to U.S. Patent Application Publication No. 2013/0146804), proposes a polishing composition containing colloidal silica in which an organic acid such as sulfonic acid is immobilized and having a pH in a specific range, as a polishing composition capable of polishing a silicon nitride film at high speed.

**SUMMARY OF THE INVENTION**

However, the polishing composition described in Japanese Patent Laid-Open No. 2012-40671 (U.S. Patent Application Publication No. 2013/0146804), has room for improvement in stability of organic acid-immobilized colloidal silica under acidic conditions. Moreover, when using the polishing composition described in Japanese Patent Laid-Open No. 2012-40671 (U.S. Patent Application Publication No. 2013/0146804), an abrasive residue on a surface of an object to be polished tends to increase even though carrying out washing after polishing, which has room for improvement in terms of reducing the residue on the surface of the object to be polished by enhancing washability thereof.

Therefore, an object of the present invention is to provide a means by which stability and washability under acidic conditions can be further improved.

In view of the aforementioned problems, the present inventors have found, as a result of diligent experimentation that the aforementioned problems can be solved by sulfonic acid-modified colloidal silica having an amount of sulfonic acid groups per 1 g of particles of 1.5 μmol or more and 13.0 μmol or less, and thus have completed the present invention.

**BRIEF DESCRIPTION OF THE PREFERRED EMBODIMENTS**

The present invention will be described below. Note that the present invention is not limited only to the following embodiments.

According to one embodiment of the present invention, sulfonic acid-modified colloidal silica having an amount of sulfonic acid groups (amount of sulfo groups) per 1 g of particles of 1.5 μmol or more and 13.0 μmol or less, is provided. According to such sulfonic acid-modified colloidal silica according to the present invention, stability under acidic conditions is further improved, and when used as abrasive grains in a polishing composition, a residue on a surface of a polished object to be polished that can be obtained after polishing can be further reduced.

The embodiments of the present invention will be described in detail below, but the present invention is not limited only to the following embodiments and can be modified in various ways within the scope of the claims. The embodiments described herein can be arbitrarily combined to provide other embodiments. In the present description, operations, measurements of physical properties and the like are conducted at room temperature (20°C or higher and 25°C or lower)/relative humidity of 40% RH or higher or 50% RH or lower, unless otherwise specified.

[Sulfonic acid-modified colloidal silica]

The sulfonic acid-modified colloidal silica according to the present invention has an amount of sulfonic acid groups per 1 g of particles of 1.5 μmol/g or more and 13.0 μmol/g or less. The sulfonic acid-modified colloidal silica of the present invention having an amount of sulfonic acid groups in such a range further improves stability under acidic conditions, and also further enhances washability after polishing, enabling reduction of residue on a surface of a polished object to be polished.

The amount of sulfonic acid groups per 1 g of particles being less than 1.5 $\mu$mol/g facilitates gelation of the sulfonic acid-modified colloidal silica under acidic conditions, resulting in reduced stability. The amount of sulfonic acid groups per 1 g of particles exceeding 13.0 $\mu$mol/g facilitates, on the other hand, adhesion of the sulfonic acid-modified colloidal silica to a surface of the polished object to be polished, thereby reducing washability after polishing and rendering it difficult to reduce a residue on the surface of the polished object to be polished. The amount of sulfonic acid groups per 1 g of particles of the sulfonic acid-modified colloidal silica according to the present invention is preferably 3.0 $\mu$mol/g or more and 10.5 $\mu$mol/g or less and more preferably 3.0 $\mu$mol/g or more and 8.5 $\mu$mol/g or less.

In the present description, the amount of sulfonic acid groups per 1 g of particles of the sulfonic acid-modified colloidal silica is a value measured by the following method.

<Measurement of amount of sulfonic acid groups>

For silica particles (sulfonic acid-modified colloidal silica) with sulfonic acid groups (-SO$_3$H) immobilized on a surface thereof, the amount of sulfonic acid groups on the surface can be calculated from the following formula, considering that 1 mol of the monovalent organic acid reacts with 1 mol of monovalent potassium ions (K+). The amount of sulfonic acid groups (unit: $\mu$mol/g) per 1 g of silica particles (as solid content) is calculated based on the following formula:

$$nS = K/Aw$$

In the above formula,

nS represents the amount of sulfonic acid groups per 1 g of silica particles after surface treatment (as solid content) [unit: $\mu$mol/g];
K represents an analytical value of potassium in the solid [unit: ppm by mass]; and
Aw represents the atomic weight of potassium [unit: g/mol]:

Specifically, first, to 21.0 g of a silica solution with a silica concentration of 19.5% by mass is added 21.0 g of a mixed solution of 0.01 mol/L hydrochloric acid and 0.01 mol/L potassium chloride, the mixture is mixed well, and then the resulting mixed solution undergoes centrifugation in accordance with the following procedure:

- Procedure: the aforementioned mixture (silica sol) is added in a dedicated tube made of resin, and undergoes centrifugation at 26, 000 rpm (26, 000 min$^{-1}$) for 2 hours, and the precipitate obtained is washed with ultrapure water, ion exchanged water or the like. Thereafter, the precipitate is evaporated to dryness and used as a sample. A high-performance high-speed refrigerated centrifuge Avanti (registered trademark) HP-30I manufactured by Beckman Coulter, Inc., is used as the centrifuge apparatus above.

The amount of potassium in the sample obtained is then measured using an inductively coupled plasma (ICP) atomic emission spectrometer, in accordance with the following procedure:

- Procedure: To 4 g of the sample obtained by the centrifugation above is added 6 mL of nitric acid and 15 mL of hydrofluoric acid, and the mixture is evaporated to dryness. After the dryness, 0.5 mL of nitric acid and approximately 20 mL of ultrapure water are added, and the mixture is heated until vapor is generated. The resulting mixture is entirely collected, and increased to 50 g with ultrapure water, and further 3.0 g thereof is taken and is increased to 30 g by addition of ultrapure water, and then measurement of the resultant is carried out using an ICP emission spectrometer (model number: ICPS-8100 manufactured by Shimadzu Corporation).

The amount of sulfonic acid groups in the sulfonic acid-modified colloidal silica according to the present invention can be controlled by the amount of a silane coupling agent used upon applying sulfonic acid modification treatment to colloidal silica that is a raw material, the conditions of oxidation treatment and the like. The production method of sulfonic acid-modified colloidal silica according to one preferred embodiment of the present invention will be described below.

[Production method of sulfonic acid-modified colloidal silica]

The production method of sulfonic acid-modified colloidal silica according to the present invention is not particularly limited, and is preferably a production method including applying sulfonic acid modification treatment to raw colloidal silica. Such a production method will be described below.

<Raw colloidal silica>

The raw colloidal silica can be, for example, produced by a sol-gel method. The raw colloidal silica produced by the sol-gel method is preferred because it contains less diffusible metallic impurities and less corrosive ions such as chloride ions in a semiconductor. Production of the raw colloidal silica by the sol-gel method can be carried out by employing previously known techniques, and specifically, the raw colloidal silica can be obtained by carrying out hydrolysis and condensation reaction by using a hydrolyzable silicon compound (for example, alkoxysilane or a derivative thereof) as a raw material. The silicon compounds may be used singly, or in combination of two or more. Moreover, raw colloidal silica may be produced by a method other than the sol-gel method.

In one embodiment of the present invention, the aforementioned silicon compound is preferably an alkoxysilane or a derivative thereof represented by the following general formula (1).

[Formula 1]

$$Si(OR)_4 \cdots \qquad (1)$$

In the general formula (1) above, R is an alkyl group, preferably a lower alkyl group having 1 or more and 8 or less carbon atoms, more preferably a lower alkyl group having 1 or more and 4 or less carbon atoms. Here, examples of above R include a methyl group, an ethyl groups, a propyl group, an isopropyl group, a butyl group, a pentyl group, a hexyl group, a heptyl group, an octyl group, and the like. Among them, tetramethoxysilane where R is a methyl group, tetraethoxysilane where R is an ethyl group, or tetraisopropoxysilane where R is an isopropyl group, is preferred. As derivatives of the alkoxysilane, a low-condensation product obtained by partial hydrolysis of alkoxysilane is also exemplified. In the present invention, tetramethoxysilane is preferably used in terms of easy control of hydrolysis rate, easy obtainment of microsilica particles, and less residue of an unreacted material.

The above silicon compounds are hydrolyzed and condensed in a reaction solvent to form colloidal silica. Water or organic solvents containing water can be used as the reaction solvent. Examples of the organic solvents include hydrophilic organic solvents such as alcohols including methanol, ethanol, isopropanol, n-butanol, t-butanol, pentanol, ethylene glycol, propylene glycol, and 1,4-butanediol, and ketones including acetone, and methyl ethyl ketone, and the like. Among these organic solvents, alcohols such as methanol, ethanol, and isopropanol, in particular, are preferably used, and from the viewpoint of aftertreatment of the reaction solvent and the like, alcohols having the same alkyl group as the alkyl group (R) of a raw silicon compound (for example, methanol for tetramethoxysilane) are more preferably used. These organic solvents may be used singly, or in combination of two or more.

The amount of the organic solvent used is not particularly limited, and is preferably about 5 moles or more and about 50 moles or less per 1 mole of a silicon compound. The amount being 5 moles or more ensures sufficient compatibility with the silicon compound, and the amount being 50 moles or less inhibits production efficiency from lowering. The amount of water added to the organic solvent is not particularly limited, as long as the amount required for hydrolysis of the silicon compound is present, and the amount is preferably about 2 moles or more and about 15 moles or less per 1 mole of the silicon compound. Note that the amount of water mixed with the organic solvent has a significant effect on the particle size of colloidal silica formed. Increasing the addition amount of water allows a particle size of colloidal silica to become larger. Decreasing the addition amount of water also enables a particle size of colloidal silica to become smaller. Therefore, change in mixing ratio of the water and organic solvent enables a particle size of the colloidal silica produced to be arbitrarily adjusted.

Preferably, to a reaction solvent for hydrolysis and condensation reaction of a silicon compound in order to obtain colloidal silica, is added a basic catalyst, and the reaction solvent is adjusted to alkaline (Stober method). According thereto, the reaction solvent is adjusted to preferably a pH of 8 or greater and a pH of 11 or less and more preferably a pH of 8.5 or greater and 10.5 or less, from which colloidal silica can be quickly formed. The basic catalyst is preferably organic amines and ammonia from the viewpoint of preventing of mixing impurities, and preferred examples thereof include in particular ethylenediamine, diethylenetriamine, triethylenetetramine, ammonia, urea, ethanolamine, and tetramethylammonium hydroxide.

In order to hydrolyze and condensate a silicon compound in the reaction solvent, the silicon compound that is a raw material may be added to an organic solvent and stirred at a temperature of usually 0°C or higher and 100°C or lower and preferably 0°C or higher and 50°C or lower. Hydrolysis and condensation of the silicon compound in an organic solvent containing water while stirring enables colloidal silica with a uniform particle size to be obtained.

Sulfonic acid-modified colloidal silica according to the present embodiment is obtained by applying modification treatment to the raw colloidal silica produced by the sol-gel method as described above in the similar manner as in the technology described in Japanese Patent Laid-Open No. 2010-269985, but improvements have been achieved over the technology described in Japanese Patent Laid-Open No. 2010-269985 in terms that colloidal silica with a reduced amount of microparticles is used as raw colloidal silica. Specifically, the sulfonic acid-modified colloidal silica according to the present embodiment is characterized in that it is formed by modification of raw colloidal silica that has a number-based percentage of 10% or less of microparticles having a particle size of 40% or less of a volume-average particle size (hereinafter also referred to simply as "microparticles"), which is based on a Heywood diameter (diameter of the equivalent circle) by image analysis using a scanning electron microscope.

When the organic solvent concentration in the colloidal silica produced by the hydrolysis and condensation reaction (sol-gel method) described above is 1% by mass or more, the number-based percentage of microparticles contained in the raw colloidal silica can be reduced to 10% or less by removing an organic solvent coexisting with the colloidal silica so that the concentration of a residual organic solvent in the colloidal silica is less than 1% by mass. Here, "whether the concentration of the residual organic solvent in the colloidal silica is less than 1% by mass" is synonymous with "whether the organic solvent is detected in the colloidal silica" in a measurement method of an organic solvent concentration (methanol concentration in Example) using gas chromatography described in Examples below. Namely, "so that the concentration of the residual organic solvent in the colloidal silica is less than 1% by mass" described above can be rephrased as "so that the organic solvent in the colloidal silica as measured by the measurement method using gas chromatography described in Examples is in the detection limit or lower".

Decreasing the concentration of the organic solvent contained in the colloidal silica in this manner enables the amount of microparticles contained in the raw colloidal silica to be reduced. In this case, it is possible that the lower the amount of the organic solvent contained in the colloidal silica, the lower the amount of microparticles contained in the raw colloidal silica. The organic solvent concentration in the colloidal silica obtained by the Stober method described above is usually 1% by mass or more. Therefore, according to other embodiment of the present invention, a production method of sulfonic acid-modified colloidal silica is provided where raw colloidal silica is obtained via a step of removing an organic solvent coexisting with colloidal silica so that a residual organic solvent concentration in colloidal silica that has a residual organic solvent concentration of 1% by mass or more, as is the case with the colloidal silica obtained by the Stober method, is less than 1% by mass, and then the raw colloidal silica is modified with sulfonic acid to obtain the sulfonic acid-modified colloidal silica.

Methods for removing an organic solvent coexisting with colloidal silica include a method for heating a colloidal silica dispersion (silica sol) and distilling away the organic solvent. In this case, replacing an organic solvent to be removed with water allows a liquid volume of the colloidal silica dispersion to be maintained. The pH of the colloidal silica dispersion when distilling away the organic solvent is preferably a pH of 7 or greater. This is an advantage in that microparticles can be incorporated on a surface of the main particles of colloidal silica by Ostwald growth in addition to removal of the organic solvent, thereby enabling the amount of microparticles to be further reduced.

The method for removing an organic solvent coexisting with colloidal silica has been described above in detail as an example of the method for reducing the number-based percentage of microparticles contained in raw colloidal silica to 10% or less, but the number-based percentage of microparticles contained in the raw colloidal silica may be reduced to 10% or less by a different method. Examples of such methods include methods of using oligomers as a raw material, optimizing a composition upon synthesis, carrying out elevated temperature and pressure treatment after synthesis, and carrying out centrifugation after synthesis, respectively, but a method other than theses may of course be employed.

<Sulfonic acid modification treatment (modification step)>

As described above, the sulfonic acid-modified colloidal silica according to the present invention is obtained by, for example, applying sulfonic acid modification treatment to the raw colloidal silica produced by the sol-gel method. This modification step includes a first reaction step of heating the raw colloidal silica described above in the presence of a silane coupling agent having a functional group capable of chemically converting to a sulfonic acid group to obtain a reaction product, and a second reaction step of treating the reaction product obtained in the first reaction step to convert the above functional group to a sulfonic acid group.

(First reaction step)

In the first reaction step, raw colloidal silica is heated in the presence of a silane coupling agent having a functional group capable of chemically converting to a sulfonic acid group. This produces a reaction product (a product in which the silane coupling agent having a functional group of capable of chemically converting to a sulfonic acid group is bonded to a surface of silica particles).

Here, various treatment steps may be applied to the raw colloidal silica obtained above before the first reaction step, if necessary. For example, a step of reducing the viscosity of the raw colloidal silica is exemplified as such a treatment step. The step of reducing the viscosity of the raw colloidal silica includes, for example, a step of adding an alkali solution (an aqueous solution of various bases such as ammonia water) or an organic solvent to the raw colloidal silica. The amount of the alkali solution or organic solvent to be added in this case is not particularly limited, and it may be appropriately set in consideration of the viscosity of the raw colloidal silica obtained after the addition. Carrying out the step of reducing the viscosity of the raw colloidal silica has an advantage of being capable of improving initial dispersibility of the coupling agent to the colloidal silica and inhibiting aggregation between the silicas.

In the first reaction step, the raw colloidal silica with a low content of microparticles as described above is heated in the presence of a silane coupling agent having a functional group capable of chemically converting to a sulfonic acid group. This produces a reaction product. The reason why the silane coupling agent having a functional group different from a sulfonic acid group is reacted with the raw colloidal silica and then the above functional group is converted to a sulfonic acid group (the second reaction step described below), is due to the fact that a silane coupling agent in the form substituted with a sulfonic acid group is generally less likely to be stably obtained.

Examples of the silane coupling agent having a functional group capable of chemically converting to a sulfonic acid group include 1) a silane coupling agent having a sulfonic acid ester group capable of converting to a sulfonic acid group by hydrolysis and 2) a silane coupling agent having a mercapto group and/or a sulfide group capable of converting to a sulfonic acid group by oxidation. Note that since sulfonic acid modification of a colloidal silica surface is carried out in solution, the latter silane coupling agent having a mercapto group and/or a sulfide group is preferably used in order to increase modification efficiency thereof. Such silane coupling agents may be used singly, or in combination of two or more. The silane coupling agent may also be commercially available or a synthetic product.

Silane coupling agents having a mercapto group include, for example, 3-mercaptopropyltrimethoxysilane, 2-mercaptopropyltriethoxysilane, 2-mercaptoethyltrimethoxysilane, 2-mercaptoethyltriethoxysilane, and the like. In addition, coupling agents having a sulfide group include, for example, bis(3-triethoxysilylpropyl)disulfide and the like.

Moreover, the silane coupling agent may be preliminarily hydrolyzed with acid followed by subjected to condensation reaction with raw colloidal silica.

As described above, when the method of removal of an organic solvent coexisting with colloidal silica is employed as a method for rendering the number-based percentage of microparticles contained in the raw colloidal silica to 10% or less, the raw colloidal silica substantially contains no organic solvent and a dispersing medium of the raw colloidal silica is substantially composed of water. Since the silane coupling agent is difficult to dissolve in water, on the other hand, a certain amount or more of an organic solvent (hydrophilic solvent) is preferably used for the purpose of dissolving the silane coupling agent. As such organic solvents (hydrophilic solvents), for example, the aforementioned organic solvents such as methanol, ethanol, isopropanol, and the like, are exemplified. In particular, the same type of alcohol as that produced by the hydrolysis of the silicon compound described above, is preferably used. This is because the use of the same type of alcohol as that produced by the hydrolysis of the silicon compound can facilitate recovery and reuse of the solvent. Note that such an organic solvent (hydrophilic solvent) may be added to the raw colloidal silica, or a silane coupling agent may be preliminarily mixed with the organic solvent (hydrophilic solvent) to obtain a mixed solution, which is then added to the raw colloidal silica, but the latter method is more preferred. In this connection, Japanese Patent Laid-Open No. 2010-269985 describes that "when considering solubility of a coupling agent, a hydrophilic organic solvent is preferably contained in colloidal silica. In this regard, when having obtained colloidal silica by the Stober method, in which an alkoxysilane was hydrolyzed and condensed in an alcohol-water solvent with a basic catalyst, alcohol is contained in the reaction solution, thereby necessitating no further addition of a hydrophilic organic solvent." However, in the preferred embodiment of the present invention, a seemingly roundabout constitution is employed where the organic solvent content in the raw colloidal silica obtained by the Stober method is once reduced to the detection limit or less followed by the addition of the silane coupling agent. According to the preferred embodiment of the present invention, it has been found that even though such a roundabout constitution is employed, the problem of the present invention can be solved. Therefore, it can be deemed that the present invention, which has been found to produce an effect that could not be foreseen by those skilled in the art despite employing the construct contrary to conventional technical knowledge as described above, could not have been easily invented even by those skilled in the art in contact with particularly the description of Japanese Patent Laid-Open No. 2010-269985.

The addition amount of the silane coupling agent used in the first reaction step is not particularly limited, and it is preferably 0.1% by mass or more and less than 1.25% by mass relative to 100% by mass of the silica particles contained in the raw colloidal silica. The addition amount of the silane coupling agent being 0.1% by mass or more sufficiently enables anionization of a surface of the silica particles, which thereby allows excellent performance to be exerted when used as a polishing agent (abrasive grains in a polishing composition) . The addition amount of the silane coupling agent being less than 1.25% by mass enables prevention of gelation of the resulting reaction product (sulfonic acid-modified colloidal silica) with an elapsed time. In particular, from the viewpoint of more improving the stability of sulfonic acid-modified colloidal silica under acidic conditions, the addition amount of the silane coupling agent is more preferably 0.25% by mass or more and 1.0% by mass or less and still more preferably 0.25% by mass or more and 0.8% by mass or less, relative to 100% by mass of the silica particles contained in the raw colloidal silica.

As other more preferred aspect of the present invention, a production method of sulfonic acid-modified colloidal silica can be provided, the method including an organic solvent removal step of obtaining raw colloidal silica by removing an organic solvent coexisting with colloidal silica under the conditions of a pH of 7 or greater so that a residual organic solvent concentration in colloidal silica having an organic solvent concentration of 1% by mass or more, is less than 1% by mass, and a modification step of subjecting the raw colloidal silica to sulfonic acid modification to obtain sulfonic acid-modified colloidal silica; wherein the modification step includes a first reaction step of heating the raw colloidal silica in the presence of a silane coupling agent having a functional group capable of chemically converting to a sulfonic acid group to obtain a reaction product, and a second reaction step of treating the reaction product to convert the functional group to a sulfonic acid group; and wherein in the first reaction step, the addition amount of silane coupling agent is 0.1% by mass or more and less than 1.25% by mass relative to 100% by mass of silica particles contained in the raw colloidal silica.

The amount of organic solvent (hydrophilic solvent) used to dissolve the silane coupling agent is preferably about 500% by mass or more and 1000% by mass or less and more preferably 1000% by mass or more and 5000% by mass more less, relative to 100% by mass of the silane coupling agent.

The temperature upon adding the silane coupling agent is not limited, and is preferably within a range of room temperature (approximately 20°C) to the boiling point of a reaction solvent. A reaction time is also not limited, and is preferably 10 minutes or longer and 10 hours or shorter, and more preferably 30 minutes or longer and 5 hours or shorter. However, from the viewpoint of completing hydrolysis of the coupling agent, the first reaction step is preferably carried out under conditions where the temperature condition of 90°C or higher is maintained for 30 minutes or longer. The pH upon addition is also not limited, and is preferably a pH of 7 or greater and a pH of 11 or less.

(Second reaction step)

In the second reaction step, the reaction product obtained in the above first reaction step (the product in which the silane coupling agent having a functional group capable of chemically converting to a sulfonic acid group is bonded to a surface of silica particles) is treated. This allows the "functional group capable of chemically converting to a sulfonic acid group" that the above silane coupling agent has to be converted to a sulfonic acid group.

The specific embodiment of the aforementioned "treatment" in order to convert the "functional group capable of chemically converting to a sulfonic acid group" that the above silane coupling agent has to a sulfonic acid group, is not particularly limited, and it may be appropriately selected according to a structure of the silane coupling agent used. For example, in the case of using a silane coupling agent having a sulfonic acid ester group capable of converting to a sulfonic acid group by the hydrolysis in 1) above in the first reaction step, the functional group (sulfonic acid ester group) of the silane coupling agent can be hydrolyzed by applying hydrolysis treatment to the above reaction product. This allows the sulfonic acid ester group to be converted to a sulfonic acid group.

Moreover, in the case of using a silane coupling agent having a mercapto group and/or a sulfide group capable of converting to a sulfonic acid group by the oxidation in 2) above in the first reaction step, applying oxidation treatment to the above reaction product enables oxidation of the functional groups (mercapto group and/or sulfide group) that the silane coupling agent has. As a result, the mercapto group or sulfide group is converted to a sulfonic acid group.

In order to apply oxidation treatment to the above reaction product, for example, the above reaction product may be reacted with an oxidizing agent. Examples of oxidizing agents include nitric acid, hydrogen peroxide, oxygen, ozone, organic peracids (percarboxylic acid), bromine, hypochlorite, potassium permanganate, chromic acid, and the like. Among these oxidizing agents, hydrogen peroxide and organic peracids (peracetic acid and perbenzoic acids) are preferred in terms of relatively favorable handleability and favorable oxidation yields. Note that hydrogen peroxide is the most preferable in consideration of byproducts produced upon reaction. From the viewpoint of securing the amount necessary for the reaction and reducing the amount of the residual oxidizing agent, the addition amount of the oxidizing agent is preferably 3 times by mole or more and 5 times by mole or less the amount of the silane coupling agent. Setting the addition amount of the oxidizing agent to the value within such a range enables the residual oxidizing agent concentration in the resulting sulfonic acid-modified colloidal silica to be minimized. The specific value of the residual oxidizing agent concentration in the resulting sulfonic acid-modified colloidal silica is not particularly limited, and is preferably 1,000 ppm by mass or less, more preferably 700 ppm by mass or less, and particularly preferably 500 ppm by mass or less. Here, with the residual oxidizing agent concentration in the resulting sulfonic acid-modified colloidal silica exceeding 1,000 ppm by mass, when the sulfonic acid-modified colloidal silica itself or a polishing composition to which the sulfonic acid-modified colloidal silica has been added as a polishing agent (abrasive grains) is stored or transported in a state of being sealed in an airtight container, an oxidizing agent such as hydrogen peroxide may decompose and generate gas such as oxygen, causing the internal pressure of the container to rise. On the other hand, reducing the residual oxidizing agent concentration in the resulting sulfonic acid-modified colloidal silica, as described above, is preferable since it lowers the risk of such an increase in internal pressure. It is advantageous that when the sulfonic acid-modified colloidal silica is used as a polishing composition, occurrence of problems such as wafer dishing, which may occur if a large amount of an oxidizing agent is contained, can also be inhibited. Since the colloidal silica and silane coupling agent each have a stable structure in the oxidation reaction except for the functional group that is oxidized (converted) to a sulfonic acid group, no byproducts are present therein.

When the sulfonic acid-modified colloidal silica obtained according to the aforementioned method contains a solvent other than water, a dispersing medium mainly composed of a reaction solvent, may be replaced with water, if necessary to enhance long-term storage stability of the sulfonic acid-modified colloidal silica. This water replacement may be carried out after addition of the silane coupling agent and before addition of the oxidizing agent. The method for replacing a solvent other than water with water is not particularly limited, and includes, for example, a method for adding water dropwise in fixed amounts while heating the sulfonic acid-modified colloidal silica. Moreover, a method for separating the sulfonic acid-modified colloidal silica from a solvent other than water by precipitation, separation, centrifugation, or the like followed by re-dispersing the sulfonic acid-modified colloidal silica in water, is also included.

The sulfonic acid-modified colloidal silica according to the present invention has a low content of microparticles composed of silica particles modified with sulfonic acid on the surface. Furthermore, the sulfonic acid-modified colloidal silica obtained by the production method according to the present invention is also preferred in terms of a reduced content of metallic impurities. Here, the metallic impurities include, for example, alkali metals such as sodium and potassium, alkaline earth metals such as calcium and magnesium, heavy metals and light metals such as aluminum, iron, titanium, nickel, chromium, copper, zinc, lead, silver, manganese, and cobalt. The sulfonic acid-modified colloidal silica according to the preferred embodiment of the present invention has a total content of metallic impurities of 1 ppm by mass or less. This total content is preferably 0.5 ppm by mass or less. The method for measuring the total content of metallic impurities shall follow the description of Examples described below. Moreover, the above sulfonic acid-modified colloidal silica does not contain halogen elements such as chlorine and bromine that are corrosive, so that it is preferred.

The particle size of the sulfonic acid-modified colloidal silica according to the present invention is not particularly limited, and is, for example, 1,000 nm or smaller, preferably 5 nm or larger and 500 nm or smaller, and more preferably 10 nm or larger and 300 nm or smaller. The particle size of sulfonic acid-modified colloidal silica shall refer to a volume-average particle size based on a Heywood diameter (diameter of the equivalent circle).

The sulfonic acid-modified colloidal silica according to the present invention is excellent in stability over a wide pH range. In particular, the sulfonic acid-modified colloidal silica according to the present invention has high stability in an acidic region. In the case of obtaining modified colloidal silica with anionic groups, a coupling agent with anionic groups is used as a modifying agent, so that the modified colloidal silica has a negative zeta potential when a dispersing medium is acidic at a pH of 2 or greater, and has high dispersion stability even when the dispersing medium is acidic. The sulfonic acid-modified colloidal silica according to the present invention also has high dispersion stability, which accordingly, renders the kinematic viscosity of the sulfonic acid-modified colloidal silica small.

[Applications]

The sulfonic acid-modified colloidal silica according to the present invention can be used for various applications such as a polishing agent (abrasive grains) contained in a polishing composition and a paper coating agent, and can be dispersed stably over a wide pH range, and also dispersed more stably particularly under acidic conditions. Moreover, the sulfonic acid-modified colloidal silica is less likely to adhere to a surface of a polished object to be polished, enabling further improvement in washability after polishing and further reduction of amount of a residue on a surface of the polished object to be polished.

Furthermore, as described above, when the sulfonic acid-modified colloidal silica according to the present invention, in which a proportion of microparticles adhering to a wafer is kept low, is used as a polishing agent (abrasive grains) particularly for CMP polishing of semiconductor wafers, fluctuation in polishing rates with an elapsed time is minimized (excellent in stability with an elapsed time), thereby enabling extremely suitable use for this application, and allowing for sufficiently addressing high performance requirements accompanying miniaturization.

Thus, according to one aspect of the present invention, a polishing composition containing the sulfonic acid-modified colloidal silica of the present invention is provided.

In addition to the sulfonic acid-modified colloidal silica of the present invention, the polishing composition according to the present invention may further contain other known components such as a dispersing medium, a pH adjusting agent, an ammonium salt as a polishing speed improver, abrasive grains other than the sulfonic acid-modified colloidal silica of the present invention, a chelating agent, a thickening agent, an oxidizing agent, a dispersing agent, a surface protection agent, a wetting agent, a surfactant, an anticorrosive (anti-corrosive agent), an antifungal agent (antiseptic agent), water-soluble polymers, and the like. The content of each of these other components may be appropriately set according to the purpose of addition thereof.

The concentration (content) of the sulfonic acid-modified colloidal silica as abrasive grains in the polishing composition according to the present invention is not particularly limited. In the case of a polishing composition (it is typically a slurry polishing solution and may be referred to as a working slurry or polishing slurry) used for polishing an object to be polished as it is, the concentration (content) of the sulfonic acid-modified colloidal silica is preferably 0.5% by mass or more, more preferably 1% by mass or more, still more preferably more than 1% by mass, particularly preferably 2% by mass or more, and most preferably 3% by mass or more, relative to the total mass of the polishing composition. The greater the concentration of the sulfonic acid-modified colloidal silica, the faster the polishing speed of the object to be polished.

Moreover, the concentration (content) of the sulfonic acid-modified colloidal silica is preferably 20% by mass or less, more preferably 15% by mass or less, still more preferably 10% by mass or less, and particularly preferably 5% by mass or less, relative to the total mass of the polishing composition. The concentration within the above range further decreases defects such as a residue derived from the sulfonic acid-modified colloidal silica.

According to one preferred specific example, the concentration (content) of the sulfonic acid-modified colloidal silica is preferably 0.5% by mass or more and 20% by mass or less, more preferably 1% by mass or more and 15% by mass or less, still more preferably 1% by mass or more and 10% by mass or less, particularly preferably 2% by mass or more and 10% by mass or less, and most preferably 3% by mass or more and 5% by mass or less, relative to the total mass of the polishing composition. The concentration (content) of the sulfonic acid-modified colloidal silica within the above range enables not only improvements in the polishing speed of an object to be polished but also reduction of a residue on a surface of a polished object to be polished.

Further, in the case of a polishing composition used for polishing after dilution (i.e., a concentrated solution), the appropriate content of the sulfonic acid-modified colloidal silica is usually 25% by mass or less and more preferably 20% by mass or less, relative to the total mass of the polishing composition, from the viewpoint of storage stability and filterability, and the like. From the viewpoint of taking advantage of providing a concentrated solution, the content of the sulfonic acid-modified colloidal silica is preferably 3% by mass or more and more preferably 5% by mass or more, relative to the total mass of the polishing composition.

The embodiments of the invention have been described in detail, but it is clear that the description is illustrative and exemplary, not limited, and that the scope of the present invention should be interpreted by the appended claims.

The present invention includes the following aspects and embodiments:

1. Sulfonic acid-modified colloidal silica, having an amount of sulfonic acid groups per 1 g of particles of 1.5 μmol/g or more and 13.0 μmol/g or less.

2. Sulfonic acid-modified colloidal silica according to 1. above, having the amount of sulfonic acid groups of 3.0 μmol/g or more and 10.5 μmol/g or less.

3. A production method of sulfonic acid-modified colloidal silica, including an organic solvent removal step of obtaining raw colloidal silica by removing an organic solvent coexisting with colloidal silica under the condition of a pH 7 or greater so that a residual organic solvent concentration in colloidal silica having an organic solvent concentration of 1% by mass or more, is less than 1% by mass, and

a modification step of subjecting the raw colloidal silica to sulfonic acid modification to obtain sulfonic acid-modified colloidal silica;
wherein the modification step includes a first reaction step of heating the raw colloidal silica in the presence of a silane coupling agent having a functional group capable of chemically converting to a sulfonic acid group to obtain a reaction product, and a second reaction step of treating the reaction product to convert the functional group to a sulfonic acid group; and
wherein in the first reaction step, an addition amount of the silane coupling agent is 0.1% by mass or more and less than 1.25% by mass relative to 100% by mass of silica particles contained in the raw colloidal silica.

4. The production method according to 3. above, wherein an addition amount of the silane coupling agent is 0.25% by mass or more and 1.0% by mass or less.

5. A polishing composition containing the sulfonic acid-modified colloidal silica according to 1. or 2. above.

[Examples]

The present invention will be described in more detail by way of the following Examples and Comparative Examples. However, the technical scope of the present invention is not limited only to the following Examples. Unless otherwise specified, "%" and "part" refer to "% by mass" and "part by mass, " respectively. In the following Examples, the operations were carried out under the conditions of room temperature (20 to 25°C)/relative humidity of 40 to 50% RH unless otherwise specified.

(Example 1)

<Synthesis of silica sol>

In a flask, 4842 g of methanol (manufactured by Kanto Chemical Co., Inc.), 750 g of water, and 178 g of a 29% by mass ammonia aqueous solution (manufactured by Kanto Chemical Co., Inc.) were mixed, and the mixture was maintained at 20°C, and thereto was added dropwise a mixed solution of 135 g of methanol (manufactured by Kanto Chemical Co., Inc.) and 508 g of tetramethoxysilane (TAMA CHEMICALS CO., LTD.) in 36 minutes of drop time. Thereafter, heat concentration and water replacement were carried out to obtain 1000 g of a silica sol having a concentration of silica particles of 19.5% by mass. The methanol concentration in this silica sol was measured by the following method using gas chromatography and was found to be less than 1% by mass (the detection limit or lower):

<<Measurement of methanol concentration using gas chromatography>>

Apparatus: Gas chromatography GC-14B
Measurement: Using a 10 μL syringe, 4 μL of a sample was extracted and injected into the above apparatus. The methanol concentration was calculated from the amounts of water and methanol obtained from the measurement.

<Synthesis of sulfonic acid-modified colloidal silica>

To 1000 g of the silica sol obtained above was added dropwise 0.25 g of 3-mercaptopropyltrimethoxysilane (product name: KBM-803, manufactured by Shin-Etsu Chemical Co., Ltd.) that was separately mixed with 4.75 g of methanol, at a flow rate of 1 mL/min, and the mixture was heated and replaced with water for 3 hours after boiling.
Next, the reaction solution was once cooled to 25°C, and 0.44 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica (anion-modified colloidal silica).

(Example 2)

To 1000 g of the silica sol synthesized by the same method as in <Synthesis of silica sol> of Example 1 was added dropwise 0.50 g of 3-mercaptopropyltrimethoxysilane (product name: KBM-803, manufactured by Shin-Etsu Chemical Co., Ltd.) that was separately mixed with 9.50 g of methanol, at a flow rate of 1 mL/min, and the mixture was heated and replaced with water for 3 hours after boiling.
Next, the reaction solution was once cooled to 25°C, and 0.88 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica.

(Example 3)

To 1000 g of the silica sol synthesized by the same method as in <Synthesis of silica sol> of Example 1 was added dropwise 0.80 g of 3-mercaptopropyltrimethoxysilane (product name: KBM-803, manufactured by Shin-Etsu Chemical Co., Ltd.) that was separately mixed with 15.2 g of methanol, at a flow rate of 1 mL/min, and the mixture was heated and replaced with water for 3 hours after boiling.
Next, the reaction solution was once cooled to 25°C, and 1.40 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica.

(Example 4)

To 1000 g of the silica sol synthesized by the same method as in <Synthesis of silica sol> of Example 1 was added dropwise 1.00 g of 3-mercaptopropyltrimethoxysilane (product name: KBM-803, manufactured by Shin-Etsu Chemical Co., Ltd.) that was separately mixed with 19.0 g of methanol, at a flow rate of 1 mL/min, and the mixture was heated and replaced with water for 3 hours after boiling.
Next, the reaction solution was once cooled to 25°C, and 1.75 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica.

(Example 5)

To 1000 g of the silica sol synthesized by the same method as in <Synthesis of silica sol> of Example 1 was added dropwise 1.5 g of 3-mercaptopropyltrimethoxysilane (product name: KBM-803, manufactured by Shin-Etsu Chemical Co., Ltd.) that was separately mixed with 28.5 g of methanol, at a flow rate of 1 mL/min, and the mixture was heated and replaced with water for 3 hours after boiling.

Next, the reaction solution was once cooled to 25°C, and 2.63 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica.

(Example 6)

To 1000 g of the silica sol synthesized by the same method as in <Synthesis of silica sol> of Example 1 was added dropwise 2.0 g of 3-mercaptopropyltrimethoxysilane (product name: KBM-803, manufactured by Shin-Etsu Chemical Co., Ltd.) that was separately mixed with 38.0 g of methanol, at a flow rate of 1 mL/min, and the mixture was heated and replaced with water for 3 hours after boiling.

Next, the reaction solution was once cooled to 25°C, and 3.50 g of 30% by mass hydrogen peroxide water (manufactured by FUJIFILM Wako Pure Chemical Corporation) was then charged and the mixture was boiled again. After boiling, the mixture was replaced with water for 2 hours, and then cooled to room temperature (25°C) to obtain sulfonic acid-modified colloidal silica.

(Comparative Example 1)

In a flask, 4080 g of methanol (manufactured by Kanto Chemical Co., Inc.), 610 g of water, and 168 g of a 29% by mass ammonia solution (manufactured by Kanto Chemical Co., Inc.) were mixed, and the mixture was maintained at 20°C, and thereto was added dropwise a mixture of 135 g of methanol and 508 g of tetramethoxysilane (TMOS) (TAMA CHEMICALS CO., LTD.) in 25 minutes of drop time. Thereafter, the mixture underwent heat concentration and water replacement under the condition of a pH of 7 or greater to obtain 1000 g of silica sol having a concentration of silica particles of 19.5% by mass. The methanol concentration in this silica sol was measured by the above method using gas chromatography and was found to be less than 1% by mass (the detection limit or lower):

To 1000 g of the silica sol obtained was added dropwise 2.5 g of 3-mercaptopropyltrimethoxysilane (product name: KBM-803, manufactured by Shin-Etsu Chemical Co., Ltd.) that was separately mixed with 22.5 g of methanol, at a flow rate of 1 mL/min, and the mixture was heated and replaced with water for 3 hours after boiling.

Next, the reaction solution was once cooled to 25°C, and 4.3 g of 30% by mass hydrogen peroxide water (manufactured by FUJIFILM Wako Pure Chemical Corporation) was then fed and the mixture was boiled again. After boiling, the mixture was replaced with water for 2 hours, and then cooled to room temperature (25°C) to obtain sulfonic acid-modified colloidal silica.

(Comparative Example 2)

To 1000 g of the silica sol synthesized by the same method as in <Synthesis of silica sol> of Example 1 was added dropwise 0.1 g of 3-mercaptopropyltrimethoxysilane (product name: KBM-803, manufactured by Shin-Etsu Chemical Co., Ltd.) that was separately mixed with 1.9 g of methanol (manufactured by Kanto Chemical Co., Inc.), at a flow rate of 1 mL/min, and the mixture was heated and replaced with water for 3 hours after boiling.

Next, the reaction solution was once cooled to 25°C, and 0.175 g of 30% by mass hydrogen peroxide water (manufactured by FUJIFILM Wako Pure Chemical Corporation) was then fed and the mixture was boiled again. After boiling, the mixture was replaced with water for 2 hours, and then cooled to room temperature (25°C) to obtain sulfonic acid-modified colloidal silica.

<Measurement of amount of sulfonic acid groups>

Taking into consideration that in silica particles with sulfonic acid groups immobilized on a surface thereof, 1 mol of monovalent organic acid (sulfonic acid) reacts with 1 mol of monovalent potassium ion ($K^+$), the amount of the sulfonic acid groups on the surface can be calculated from the following formula. The amount of sulfonic acid groups (unit: $\mu$mol/g) per 1 g of silica particles (as solid content) was calculated based on the following formula:

$$nS = K/Aw$$

In the above formula,

nS represents the amount of sulfonic acid groups per 1 g of silica particles after surface treatment (as solid content) [unit: $\mu$mol/g];
K represents an analytical value of potassium in the solid [unit: ppm by mass]; and
Aw represents the atomic weight of potassium [unit: g/mol]:

Specifically, first, to 21.0 g of a silica solution with a silica concentration of 19.5% by mass was added 21.0 g of a mixed solution of 0.01 mol/L hydrochloric acid and 0.01 mol/L potassium chloride, the mixture was mixed well, and then the resulting mixed solution underwent centrifugation in accordance with the following procedure:

- Procedure: the aforementioned mixture (silica sol) was added in a dedicated tube made of resin, and underwent centrifugation at 26, 000 rpm (26, 000 min$^{-1}$) for 2 hours, and the precipitate obtained was washed with ultrapure water or ion exchanged water or the like. Thereafter, the precipitate was then evaporated to dryness and used as a sample. A high-performance high-speed refrigerated centrifuge Avanti (R) HP-30I manufactured by Beckman Coulter, Inc., was used as the centrifuge apparatus above.

The amount of potassium (K in the formula above) in the sample obtained was then measured using an inductively coupled plasma (ICP) atomic emission spectrometer, in accordance with the following procedure:

- Procedure: To 4 g of the sample obtained by centrifugation above was added 6 mL of nitric acid and 15 mL of hydrofluoric acid, and the mixture was evaporated to dryness. After the dryness, 0.5 mL of nitric acid and approximately 20 mL of ultrapure water were added, and the mixture was heated until vapor was generated. The resulting mixture was entirely collected, and increased to 50 g with ultrapure water, and further 3.0 g by weight of the liquid was taken therefrom, and the liquid was increased to 30 g by addition of ultrapure water, and then measurement of the resultant was carried out using an ICP emission spectrometer (model number: ICPS-8100 manufactured by Shimadzu Corporation).

[Evaluation]

(Washability evaluation)

The sulfonic acid-modified colloidal silica obtained in the above Examples and Comparative Examples was observed for adhesiveness to a silicon nitride (SiN) wafer. Apparatus: A scanning electron microscope SU8000

(manufactured by Hitachi High-Tech Corporation)

SiN wafer: A SiN wafer manufactured by Advantech Co., Ltd. Procedure: The obtained sulfonic acid-modified colloidal silica was diluted to a silica concentration of 14% by mass using pure water to prepare dispersion having a pH of 3 with a pH adjusting agent. A SiN wafer was immersed in this dispersion for 30 seconds and then rocked in pure water for 10 seconds. Thereafter the wafer was completely dried with $N_2$ gas, and then was observed in ten fields of view by using a scanning electron microscope SU8000 at a magnification of 50,000x.
Evaluation: The SiN wafer was observed by SEM after drying, and the proportion of the area with particles attached was evaluated using the following evaluation criteria when the total area of the 10 fields of view in total at a magnification of 50,000x was regarded as 100%.

A: 10% or less (extremely favorable washability)
B: More than 10% or 30% or less (favorable washability)
C: More than 30% and 50% or less (no major problems in washability)
D: More than 50% (poor washability)

(Stability test)

Each 100 g of the sulfonic acid-modified colloidal silica prepared in the above Examples and Comparative Examples was separated and adjusted to a pH of 2 and a pH of 3, respectively, using a 0.1 mol/L HCl solution and a 0.1 mol/L NaOH solution as pH adjusting agents. They were sealed and stored in an air bath at 80°C for 24 hours.

After 24 hours, each sample was taken out from the air bath and confirmed to reach solution temperature of room temperature (25°C), and then presence or absence of precipitation or gelation was visually observed.

Each sample was evaluated and determined as (A) favorable when no change from before storage at 80°C was observed, (B) slightly poor when slight precipitation was observed, and (C) poor when drastic precipitation was observed or the sample gelled.

Table 1 below shows the amounts of sulfonic acid groups in the sulfonic acid-modified colloidal silica and evaluation results for Examples and Comparative Examples. [Table 1]

Table 1

|  | Addition amount of silane coupling agent in production (% by mass relative to silica particles solid content) | Amount of sulfonic acid groups ($\mu$mol/g) | Washability evaluation | Stability | |
|---|---|---|---|---|---|
|  |  |  |  | pH2 | pH3 |
| Example 1 | 0.125 | 2.0 | A | A | A |
| Example 2 | 0.25 | 3.2 | A | A | A |
| Example 3 | 0.4 | 5.9 | A | A | A |
| Example 4 | 0.5 | 6.1 | B | A | A |
| Example 5 | 0.75 | 8.1 | B | A | A |
| Example 6 | 1.0 | 10.2 | B | A | A |
| Comparative Example 1 | 1.25 | 13.2 | D | A | A |
| Comparative Example 2 | 0.05 | 1.3 | A | C | C |

As shown in Table 1 above, the sulfonic acid-modified colloidal silica of Examples 1 to 6 according to the present invention was found to have excellent stability and washability under acidic conditions. The sulfonic acid-modified colloidal silica of Comparative Example 1, on the other hand, in which the amount of sulfonic acid groups exceeded 13.0 $\mu$mol/g, was found to have poor washability. The sulfonic acid-modified colloidal silica of Comparative Example 2, in which the amount of sulfonic acid groups was less than 1.5 $\mu$mol/g, was found to have poor stability under acidic conditions.

This application is based on Japanese Patent Application No. 2022-053011 filed on March 29, 2022, the content of which is hereby incorporated by reference in its entirety.

**Claims**

1. Sulfonic acid-modified colloidal silica, wherein an amount of sulfonic acid groups per 1 g of particles is 1.5 $\mu$mol/g or more and 13.0 $\mu$mol/g or less.

2. Sulfonic acid-modified colloidal silica according to claim 1, wherein the amount of sulfonic acid groups is 3.0 $\mu$mol/g or more and 10.5 $\mu$mol/g or less.

3. A production method of sulfonic acid-modified colloidal silica, comprising

an organic solvent removal step of removing an organic solvent coexisting with colloidal silica under the condition of a pH of 7 or greater to obtain raw colloidal silica so that a residual organic solvent concentration in colloidal silica having a concentration of the organic solvent being 1% by mass or more becomes less than 1% by mass; and

a modification step of modifying the raw colloidal silica with sulfonic acid to obtain sulfonic acid-modified colloidal silica,

wherein the modification step comprises a first reaction step of heating the raw colloidal silica in the presence of a silane coupling agent having a functional group capable of chemically converting to a sulfonic acid group to obtain a reaction product, and a second reaction step of treating the reaction product to convert the functional group to a sulfonic acid group, and

wherein in the first reaction step, an addition amount of the silane coupling agent is 0.1% by mass or more and less than 1.25% by mass relative to 100% by mass of silica particles contained in the raw colloidal silica.

4. The production method according to claim 3, wherein an addition amount of the silane coupling agent is 0.25% by mass or more and 1.0% by mass or less.

5. A polishing composition containing the sulfonic acid-modified colloidal silica according to claim 1.

Europäisches
Patentamt

European
Patent Office

Office européen
des brevets

## EUROPEAN SEARCH REPORT

Application Number

EP 23 16 2577

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 112 429 741 A (SHANGHAI XINANNA ELECTRONIC TECH CO LTD ET AL.) 2 March 2021 (2021-03-02) * claim 2; examples 1-6 * | 1,2 | INV. C01B33/146 C09G1/02 C09K3/14 |
| A | US 2010/108277 A1 (MEISEL KARLHEINRICH [DE] ET AL) 6 May 2010 (2010-05-06) * example all * | 1-5 | |
| A | WO 2010/134542 A1 (FUSO CHEMICAL CO LTD [JP]; AMANAI YASUHITO [JP] ET AL.) 25 November 2010 (2010-11-25) * example all * | 1-5 | |

TECHNICAL FIELDS
SEARCHED (IPC)

C01B
C09G
C09K

The present search report has been drawn up for all claims

| Place of search | Date of completion of the search | Examiner |
|---|---|---|
| The Hague | 25 August 2023 | Mattheis, Chris |

EPO FORM 1503 03.82 (P04C01)

## ANNEX TO THE EUROPEAN SEARCH REPORT
## ON EUROPEAN PATENT APPLICATION NO.

EP 23 16 2577

This annex lists the patent family members relating to the patent documents cited in the above-mentioned European search report.
The members are as contained in the European Patent Office EDP file on
The European Patent Office is in no way liable for these particulars which are merely given for the purpose of information.

25-08-2023

| Patent document cited in search report | | Publication date | Patent family member(s) | | Publication date |
|---|---|---|---|---|---|
| CN 112429741 | A | 02-03-2021 | NONE | | |
| US 2010108277 | A1 | 06-05-2010 | AT | 502158 T | 15-04-2011 |
| | | | CN | 1816663 A | 09-08-2006 |
| | | | CN | 101824775 A | 08-09-2010 |
| | | | DE | 102004020112 A1 | 20-01-2005 |
| | | | DK | 1644579 T3 | 29-09-2008 |
| | | | EP | 1961862 A1 | 27-08-2008 |
| | | | ES | 2308192 T3 | 01-12-2008 |
| | | | ES | 2361132 T3 | 14-06-2011 |
| | | | JP | 4833839 B2 | 07-12-2011 |
| | | | JP | 2007527471 A | 27-09-2007 |
| | | | PL | 1961862 T3 | 31-08-2011 |
| | | | PT | 1644579 E | 16-09-2008 |
| | | | PT | 1961862 E | 17-05-2011 |
| | | | SI | 1644579 T1 | 31-12-2008 |
| | | | SI | 1961862 T1 | 30-06-2011 |
| | | | US | 2010108277 A1 | 06-05-2010 |
| WO 2010134542 | A1 | 25-11-2010 | JP | 2010269985 A | 02-12-2010 |
| | | | TW | 201100327 A | 01-01-2011 |
| | | | WO | 2010134542 A1 | 25-11-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012040671 A
- US 20130146804
- JP 2010269985 A
- JP 2022053011 A